(19) **Europäisches Patentamt**
**European Patent Office**
**Office européen des brevets**

(11) **EP 2 172 091 B1**

(12) **EUROPEAN PATENT SPECIFICATION**

(45) Date of publication and mention of the grant of the patent:
**06.10.2010 Bulletin 2010/40**

(51) Int Cl.:
**H05K 13/04** (2006.01)

(21) Application number: **08766824.0**

(22) Date of filing: **19.06.2008**

(86) International application number:
**PCT/NL2008/050401**

(87) International publication number:
**WO 2008/156362 (24.12.2008 Gazette 2008/52)**

(54) **PLACEMENT DEVICE AND ASSEMBLY DEVICE COMPRISING A PLACEMENT DEVICE**

PLATZIERUNGSEINRICHTUNG UND BESTÜCKUNGSEINRICHTUNG MIT EINER PLATZIERUNGSEINRICHTUNG

DISPOSITIF DE PLACEMENT ET DISPOSITIF D'ASSEMBLAGE COMPRENANT CE DISPOSITIF DE PLACEMENT

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **19.06.2007 EP 07110562**

(43) Date of publication of application:
**07.04.2010 Bulletin 2010/14**

(73) Proprietor: **Nederlandse Organisatie voor Toegepast -Natuurwetenschappelijk Onderzoek TNO 2628 VK Delft (NL)**

(72) Inventors:
• **VAN SCHIJNDEL, Jorg Balder NL-5672 EH Nuenen (NL)**

• **GORTZEN, Roger 5611 VH Eindhoven (NL)**
• **PLAK, Ronald 1738 DD Waarland (NL)**

(74) Representative: **Hatzmann, Martin et al Vereenigde Johan de Wittlaan 7 2517 JR Den Haag (NL)**

(56) References cited:
**WO-A-2005/048677    JP-A- 1 135 000**
**JP-A- 9 246 790    JP-A- 2007 027 408**
**US-A- 5 957 305**

**Description**

FIELD OF THE INVENTION

The invention relates to a placement device.
The invention further relates to an assembly device comprising a placement device.
The invention still further relates to a method to calculate a characteristic of a part of the placement device.

BACKGROUND

Placement .devices are used for assembling components, e.g. components in hybrid microsystems, or for placing components on a substrate, e.g. a printed circuit board. Additionally placement devices may be used for other pick & place activities, such as taking components from a component supply belt and placing them on a location for further processing. The placement device uses a gripper to subsequently pick-up and position a component, and to subsequently attach the component to a substrate or other product if applicable. During the collision of the gripper with the component against the surface where it is to be positioned the material around the contact points between base structure, component and gripper act as a damped spring system. Most of the kinetic energy from the gripper will be converted to spring energy by elastic deformation of the material around the contact points. The stored spring energy will be partially converted back to kinetic energy of the gripper at the end of the collision. The gripper will therefore rebounce unless a force is present on the gripper that maintains the contact force between gripper, component and base structure. A rebounce is undesired as it causes a second impact, which increases the risk of damages of the component and/or substrate. Furthermore, the rebounce may cause vibrations in the placement device that cause significant inaccuracies in the placement of the component.
The standard solution for preventing the gripper from rebouncing is to place a pretensioned spring with low stiffness between the gripper and the drive unit. If the extra force of the pretensioned spring is strong enough the contact force will be maintained during the collision and the gripper will not rebounce. However, due to this extra force from the pretensioned spring the deformations and the maximum impact force will also increase, which is harmful for the components and/or the substrate.
An alternative placement device is described in US2005/0035613. The gripper described therein is mounted coaxially in a holder. A pretension is applied to the gripper by an electric or magnetic field. In this way the placing force is independent on the distance covered by the gripper relative to the holder when placing objects onto a substrate.

SUMMARY OF THE INVENTION

It is desired to provide a placement device wherein a rebounce of the gripper is prevented while maintaining impact forces at a modest level. According to the invention a placement device is provided comprising a gripper, a holder and a resilient structure, the gripper and the holder being at least moveable relative to each other along a first axis, wherein the resilient structure biases the gripper in a reference position relative to the holder by exerting a resultant force in a first direction upon a change of the relative position of the gripper opposite to the first direction, wherein the resilient structure comprises a first resilient portion having a relatively low stiffness and a second resilient portion having a relatively high stiffness, the first resilient portion being pretensioned. It is a further purpose of the invention to provide an assembly device having these advantages It is a still further purpose of the invention to provide a method to calculate a characteristic of a part of the placement device.
In a device according to the present invention the first resilient portion having a relatively low stiffness and the second resilient portion having a relatively high stiffness cooperate to realize that a force exerted by the gripper increases relatively fast to a value sufficiently strong to prevent the gripper from bouncing back. Once this sufficiently strong level is reached the force exerted remains relatively independent of the displacement of the gripper relative to the holder, hereinafter also denoted as relative displacement of the gripper. In some applications the component need not only be positioned on a surface, such as a substrate, but must be attached to the surface by pressure. In such applications the force exerted on the gripper may be higher than the minimal required force to prevent a bouncing back of the gripper. Nevertheless also in those applications the force exerted by the gripper should b.e modest, in order to prevent damages in particular to prevent that components are damaged.
A resilient structure is understood to be any structure that has the capacity to return to its original shape or state and therewith exerts a force causing the change to be undone. Such a structure may include springs e.g. spiral or leaf springs, from a metal for example. Alternatively air springs can be used or the structure can be constructed from elastic materials such as foam. For the first resilient portion it is not essential that the force exerted increases with the amount of deformation. E.g. the first resilient portion may be an air spring having a constant pressure .regulation. Alternatively the first resilient portion may use electric or magnetic fields to restore its original shape.
It is remarked that JP 2007-027408 describes a suction nozzle mechanism having a first compression coil spring having a small spring constant $k1$ and a free length $L1$ and a second compression coil spring having a large spring constant $k2$ and having a free length $L2$

smaller than L1. When the suction nozzle is compressed over a .small distance only the first compression coil is compressed, so that the suction nozzle exerts a relatively low force at the object to be picked up. When the suction nozzle is compressed over a relatively large distance also the second compression coil is compressed so that a relatively large force is exerted at the object when it is placed on a target.

Accordingly, contrary to the placement device according to the present invention, the force exerted by the device disclosed in the Japanese document in increases relatively slowly as a function of displacement until the displacement becomes larger than the free length of the second compression coil spring and increases relatively fast at a further displacement.

The placement device according to the invention having a resilient structure with a first resilient portion having a relatively low stiffness and a second resilient portion having a relatively high stiffness provides for a resultant force on the gripper increases relatively fast to a value sufficiently strong to prevent the gripper from bouncing back makes while the exerted force remains modest. Moreover the present invention allows this force displacement characteristic to be achieved without complex mechatronic control means.

For the purpose of the present invention it is not relevant how the gripper holds the component. Dependent on the type of components to be mounted various technologies may be used, e.g. the gripper may have a vacuum head, use magnetic forces or comprise a clamp.

The placement device according to the invention can be realized in different ways. In a first embodiment the first resilient structure has a first end exerting a force in the first direction, and a range limiter for limiting a movement of the first end in the first direction. The second resilient portion exerts a force between the gripper and the first end of the first resilient portion. If the gripper collides with the substrate the gripper causes the second resilient portion to deform. Initially the force exerted by the second resilient portion on the gripper, increases rapidly with the relative displacement of the gripper until a predetermined value has been reached. After this point the first resilient portion starts deforming and the relative position has no significant influence on the force build-up anymore. In a second embodiment the first resilient portion exerts a first force upon the gripper in the first direction along the first axis. The second resilient portion exerts a second force opposite to said first direction upon the gripper until the change in relative position exceeds the predetermined value.

The second resilient portion may be pretensioned, but this is not necessary. For example in the second embodiment, a working range of the second resilient portion may be limited by a range limiter that externally prevents the second resilient portion to expand beyond a predetermined range. Alternatively the second resilient portion may itself have a range equal to the predetermined range. In that case the second resilient portion may be mounted either exclusively to the gripper or exclusively to the holder, so that it does not exert a negative force if its range is exceeded. As soon as the change in relative position of the gripper from its reference position exceeds the predetermined value, the second resilient portion no longer contributes to the mechanical coupling between the gripper and the holder and therewith ceases to exert a force opposite to said first direction.

In a preferred embodiment the holder and the gripper are coupled by tilting member allowing the gripper to tilt away from the first axis. In this way the holder can make small lateral displacements without causing lateral displacements of the component or stress build-up in the gripper after the collision of the gripper with the component and the substrate where it is to be mounted or the surface where it is to be placed.

In a preferred implementation of the latter embodiment a position dependent tilt limiter limits the orientation of the gripper to a reference orientation when the gripper is in its reference position relative to the holder. In this way the gripper has a predetermined reference orientation, preferably aligned along the first axis, at least until the moment that it contacts the substrate. As soon as the gripper displaces along its first axis due to contact forces that come into existence when the gripper with the component touches the substrate the gripper is allowed to tilt.

The tilting member may comprise any suitable parts that allow the gripper to tilt away from the first axis, e.g. a hinge, a flexible rod. The tilting member may allow for a tilt in a single angular direction or in a range of angular directions. The magnitude of the tilt may be limited within a predetermined range. A practical embodiment has been found to be a displacement device wherein the tilting member is formed by a membrane mounted in a plane transverse to the first axis. The membrane biases the orientation of the gripper along the first axis, but allows the gripper to tilt from the first axis in an arbitrary direction.

The membrane alone may serve as a first resilient portion that exerts a first force upon the gripper in the first direction along the first axis. In an embodiment the displacement device includes a pretensioning structure for applying a pretension to the membrane in the first direction. In this way it is easier to tune the resulting force upon the gripper in the first direction, and the force with which the membrane resists against a deviation of the orientation of the gripper from the first axis.

The membrane alone may also serve as a second resilient portion. In an embodiment the membrane can be pretensioned with a first resilient portion, e.g. an air spring.

The position dependent tilt limiter preferably includes a stop piece on the gripper and a support structure on the holder, wherein the first resilient portion forces the stop piece to the support structure in an unloaded state of the gripper. In the unloaded state, the forced contact of the stop piece against the support structure restricts a tilt of the gripper. When the gripper is depressed upon contact of the gripper with the component on the substrate the restriction is gradually cancelled. In an implementation one or both of the stop piece and the support structure may comprise a resilient material, and therewith serve as a second resilient portion.

Damping is understood to be the development of a force that counteracts a movement, proportional to the velocity of a movement. Damping in the movement between the gripper and the holder is generally inherently present and desired as it supports in reducing vibrations. However it is difficult to tune the behaviour of the system comprising placement device, component and substrate by dimensioning the damping alone. Accordingly it is preferred to add no additional damping to the damping inherently present and to control the behaviour of the system by dimensioning the resilient coupling between gripper and holder. In this case the mechanical behaviour of the system comprising placement device, component and substrate can still be optimized by tuning a spring constant of the resilient structure and using the damping of the substrate in this system. Preferably the characteristics e.g. a spring constant of the resilient structure are based on an observed behaviour of the system comprising placement device, component and substrate. This behaviour is determined by damping in the movement between gripper and holder, damping in the component and the substrate and loss of energy during the collision.

A suitable method to calculate the desired spring constant or other desired characteristic of the resilient structure of a placement device according to one of the previous claims, comprises the steps of

- causing a predetermined load to collide with the substrate,
- measuring a characteristic of vibrations of the substrate/gripper resulting from the collision,

calculating the desired characteristic of the resilient structure from the measured characteristic.

An assembly device according to the present invention comprises a placement device as described above .and further comprises a displacement device for relatively displacing the placement device in a direction along the first axis as well as a direction transverse to the first axis. The displacement device may cause relative displacement transverse to the first axis by displacing the substrate or by displacing the placement device, or by a combination of both.

BRIEF DESCRIPTION OF THE DRAWING

These and other aspects of the invention are described in more detail with reference to the drawing. Therein

Figure 1 schematically shows an assembly device wherein a placement device according to the invention can be used,

Figure 2 shows a first embodiment of a placement device according to the invention,

Figures 2A, 2B and 2C shows a portion of this first embodiment in three different operational states,

Figure 3 shows a relationship between a force exerted on the gripper as a function of the displacement of the gripper relative to the holder,

Figure 4 shows a second embodiment of a placement device according to the invention,

Figure 5 shows a third embodiment of a placement device according to the invention,

Figure 6 illustrates consequences of a deviation of a lateral position of the gripper,

Figure 7A and 7B schematically shows a fourth embodiment of a placement device according to the invention in a first and a second operational state,

Figure 8A and 8B schematically shows a fifth embodiment of a placement device according to the invention in a first and a second operational state,

Figure 9A shows an absolute displacement of the gripper as a function of time for a placement device according to the invention in comparison with placement devices not according to the invention,

Figure 9B shows forces occurring between the gripper and the component as a function of time for a placement device according to the invention in comparison with placement devices not according to the invention.

DETAILED DESCRIPTION OF EMBODIMENTS

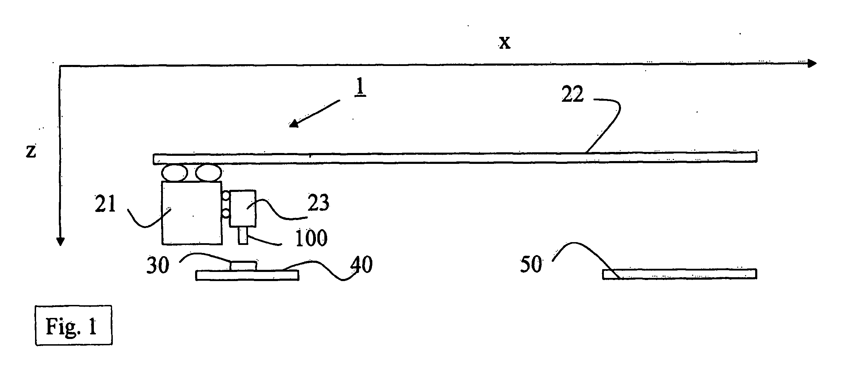

Figure 1 schematically shows an assembly device 1. The assembly device 1 comprises a placement device 100 and a displacement device for relatively displacing the placement device in a direction along a first axis (z) as well as a direction transverse to the first axis (x). The displacement device comprises a first sledge 21 that is moveable along the x-axis along a rail 22, and a second sledge 23 that is movable with relatively to the first sledge 21 in the z-direction. The placement device 100 is arranged to grip a component 30 from a conveyor belt 40 for example and after being displaced by the displacement device 21, 22, 23 mount this to a printed circuit board 50.

Although in the embodiment the first sledge 21 moves the placement device 100 in a direction orthogonal to the z-direction the movement direction of the sledge may be in a direction orientated at another non-zero angle with the z-axis. Alternatively the displacement device may be capable of displacing the placement device in a range of directions.

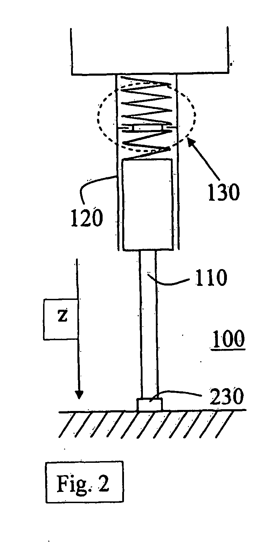

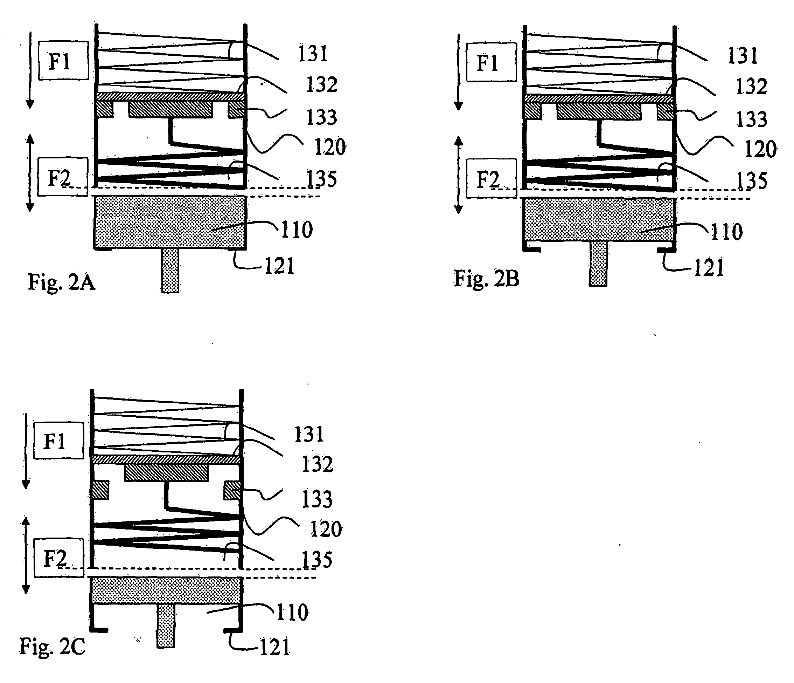

Figure 2 schematically shows a first embodiment of a placement device 100 according to the invention. The placement device comprises a gripper 110, a holder 120 and a resilient structure 130. The gripper 110 and the holder 120 are at least moveable relative to each other along a first axis, the z-axis. The resilient structure 130 biases the gripper 110 in a reference position relative to the holder by exerting a resultant force in a first direction (along the z-axis) upon a change of the relative position of the gripper opposite to the first direction (contrary to the z-axis). As shown in more detail in Figure 2A, the resilient structure 130 comprises a first resilient portion 131 having a relatively low stiffness and a second resilient portion 135 having a relatively high stiffness. The first resilient portion is pretensioned.

In particular the first resilient portion 131 has a first end 132 exerting a force F1 in the first direction, and a range limiter in the form of a ring 133 mounted in the holder 120 for limiting a movement of the first end 132 in the first direction. The second resilient portion exerts a force F2 between the gripper 110 and the first end 132 of the first resilient portion 131.

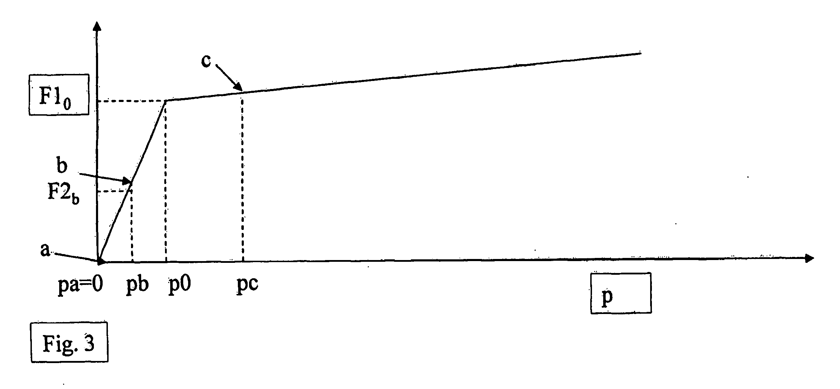

The operation of the embodiment shown in Figures 2 and 2A is illustrated with reference to Figure 3. Therein the value p along the horizontal axis shows the position of the gripper 110 relative to the holder. A position p=0 (situation a) indicates the reference position wherein the gripper 110 is biased by the resilient structure 130 against an end 121 of the holder 120 as shown in Figure 2A. Figure 2B shows the situation wherein the gripper 110 is relatively displaced in the z-direction. Due to this displacement pb the second resilient portion 135 is compressed as a result of which a spring tension F2b is developed in the second resilient portion. The spring tension F2 is related to the displacement p in this region by the relation:

F2 = k2.p, wherein k2 is a spring constant of second resilient portion. With increasing displacement of the gripper 110 the force exerted by the gripper on the substrate rapidly increases with this relation until the force exceeds the force F1 that is exerted by the first resilient portion 131. At that moment the second resilient portion 135 starts to press the end 132 of the first resilient portion 131 from the range limiter 133, as shown in Figure 2C.

From that moment the effective stiffness is determined by the combination of the springs and the force only increases with the slope

$$k' = \frac{k_1 . k_2}{k_1 + k_2}$$

The value k' is less than $k_2$, as $k_2 > k_1$.

Accordingly after the force exerted by the spring has reached the desired value Flo, it only modestly increase, even if the gripper has a substantial relative displacement.

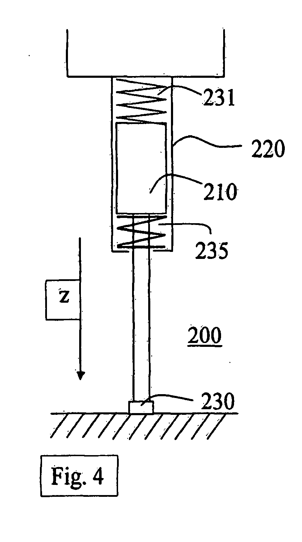

Figure 4 shows a second embodiment. Parts therein corresponding to those in Figure 2 have reference number that is 100 higher. In that embodiment the first resilient portion exerts a first force F1 upon the gripper in the first direction along the first axis, the z-axis, and the second resilient portion exerts a second force F2 opposite to said first direction upon the gripper until the change in relative position exceeds the predetermined value.

In the reference position the net force exerted on the gripper 210 is zero, as the individual forces exerted by the first and the second resilient portion 231, 235 are balanced. When the gripper 210 with a component touches the substrate, the gripper is depressed, resulting in an increasing tense on the first resilient portion 231 and a relaxation of the second resilient portion 235.

Accordingly if the gripper 210 is depressed over a distance p, the net force exerted on the gripper 210 increases relatively strongly with $(k_1+k_2).p$, until the depression p exeeds the range of the second resilient portion 235. The range of the second resilient portion 235 may be limited autonomously or by a range limiter present in the holder 220. Once the range is exceeded the net force exerted on the gripper 210 only increases relatively slowly with $k_1.p$, so that a comparable force-displacement characteristic is obtained as with the embodiment shown in Figure 2.

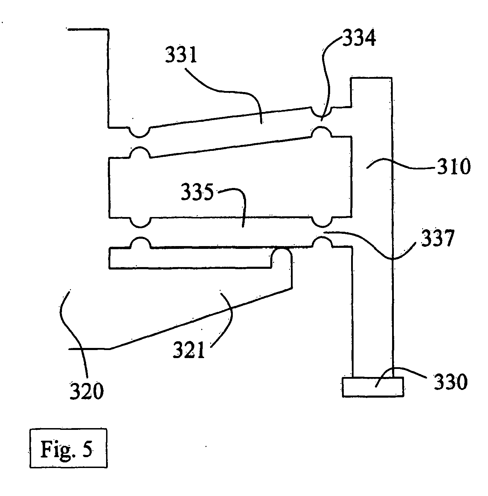

Figure 5 shows a third embodiment of a placement device according to the invention. Parts therein corresponding to those in Figure 2 have reference number that is 200 higher. In the placement device of Figure 5 the gripper 310 is guided by a first 331 and a second leaf spring 335. Both leaf springs are pretensioned. The gripper 310 is coupled to narrowed end portions 334, 337 of the leaf springs. These end portions 334, 337 function as hinges. As long as the second leaf spring 335 is supported by the support structure 321, a relatively small portion of the second leaf spring 335 extending beyond the support structure 321 determines the effective stiffness of the resilient structure 331, 335. This relatively small portion of the second leaf spring 335 forms the second resilient portion. At the moment that the second leaf spring 335 comes apart from the support structure 321 then the resulting stiffness is determined by the combination of the leaf springs. The combination of the leaf springs 331, .335 forms a first resilient portion. As the total length of these springs 331, 335 is substantially longer than the relatively small portion of the second leaf spring 335 extending beyond the support structure 321, this combination has a substantially lower stiffness, so that the force exerted by the resilient structure 331, 335 only modestly increases with further displacement of the gripper 310. This construction has the advantage that it can be realized with relatively simple means. In practice this construction almost can be realized from a single piece of material, e.g. by laser cutting of a plate of spring steel. A disadvantage is however that the construction is not symmetric. This may have the consequence that vibrations in the resilient structure after a collision also have lateral components, which cause displacement inaccuracies.

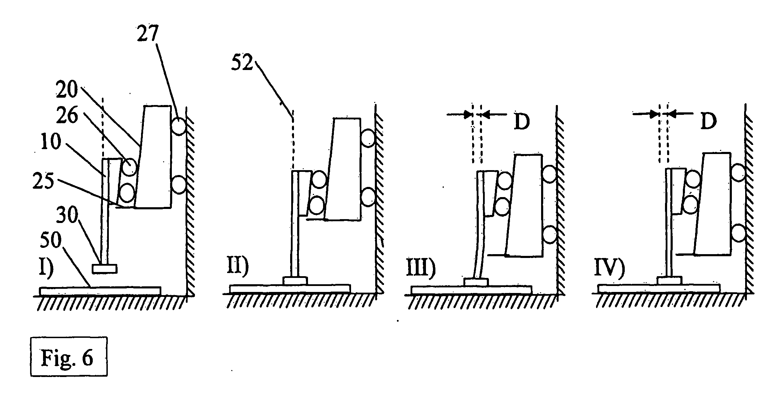

Figure 6 schematically shows in four subsequent situations I-IV a collision of a gripper 10 with a component 30 against a substrate 50. The gripper 10 is movably coupled to a holder 20 via a guidance 26 and restricted by a support structure 25. In situation I the gripper 10 with component 30 approaches the substrate 50. In situation II the gripper 10 with the component 30 makes initial contact with the substrate. At this moment, when the gripper 10 stops its movement the component 30 is placed at a position indicated by reference line 52. As shown schematically in situation III during the movement of the gripper relative to the holder 20, the gripper may also incur a lateral displacement D for example because the relative movement of the gripper 10 is not fully aligned with the direction of movement of the holder 20, as shown here. Due to this lateral displacement, either a tension may be built up in the gripper 10 in case of a high friction between component and substrate as shown in situation III, or, as shown in situation IV the component may be displaced from the position where it was originally placed in case of a relatively low friction between component and substrate.

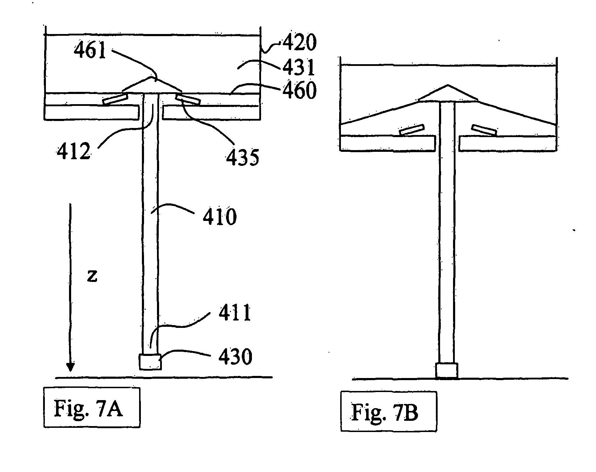

In a fourth embodiment of the placement device according to the invention, shown in Figures 7A, 7B the holder and the gripper are coupled by a tilting member 460 allowing the gripper to tilt away from the first axis. Parts therein corresponding to those in Figure 2 have a reference number that is 200 higher. The tilting member is formed by a membrane 460 oriented transverse to the first axis z. The gripper 410 is mounted with a flange 461 to the membrane 460. In a preferred embodiment the flange 461 is mounted on top of the membrane 460 such that the center of gravity of the combination of gripper 410, component 430 and flange 461 is close to the rotation point of the membrane 460. A support structure 435 functions as the second resilient portion. In the embodiment shown the support structure is a cupped spring washer. The first resilient portion 431 is an air chamber. This functions as a pretensioning structure for applying a pretension to the membrane 460 in the first direction.

In the reference position of the gripper, shown in Figure 7A, the pretensioning structure presses the flange 461 of the membrane 460 to the support structure 435. The flange 461 forms a stop piece on the gripper 410. Accordingly the flange 461 and the support structure 435 forces the gripper into a reference position and therewith function as a position dependent tilt limiter. In Figure 7B, showing schematically a depressed position of the grippe 410, the stop piece 461 is released from the support structure 435 and allows the gripper 410 to tilt. This tilting movement compensates for the lateral displacement D (Fig. 6) of the end 412 of the gripper 410. Accordingly, in the situation shown in Figure 7B no tension is built up in the gripper 410 contrary to the situation III shown in Figure 6. Also a displacement of the component 430 as in situation IV shown in Figure 6 is prevented. To facilitate a tilting movement between the gripper 410 and the component 430 the top 411 of the gripper 410 may be made of a flexible material, e.g. of rubber.

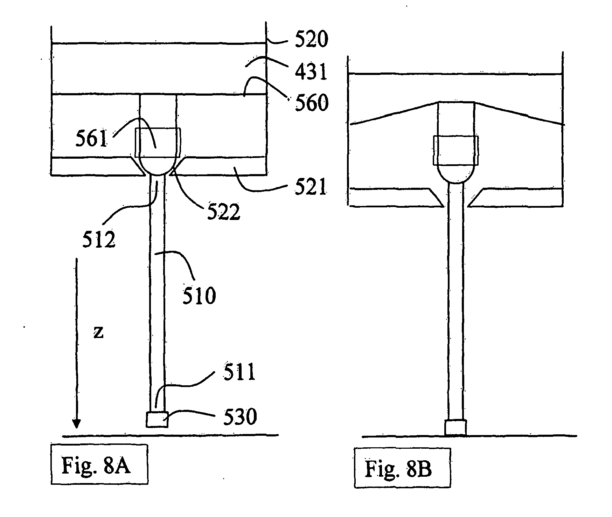

Figure 8A and 8B schematically shows a fifth embodiment of the invention. Parts therein corresponding to those in Figure 2 have a reference numeral that is 400 higher. In the embodiment shown therein the gripper 510 has a widened portion 561 that cooperates with a tapered hole 522 in a disc 521 of resilient material. The disc functions as second resilient portion. In the reference position of the gripper 510 tilt thereof is limited by the cooperating widened portion 561 and recess 522. After depression of the gripper 510 (Figure 8B) the more narrow part 512 of the gripper is allowed to move laterally within the hole 522.

In a practical application the embodiment of Figure 7A was carried out as follows:

The stiffness of the high stiffness spring and the low stiffness spring was 300 N/mm, and 60 N/mm respectively. The pretension force of the springs was 5N, and the gripper with a mass of 4.4 g was applied with a collision speed of 150 mm/s.

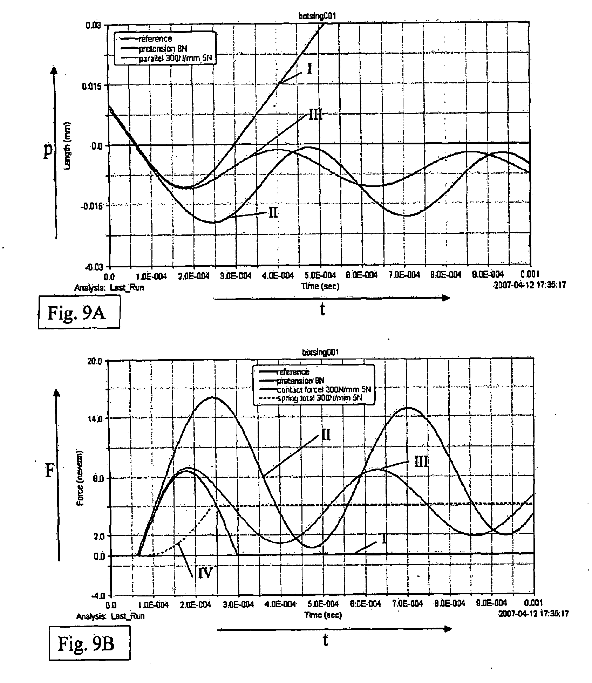

A simulation result is shown in Figure 9A. Figure 9A shows the displacement p of the gripper as a function of time t. At p is 0, the gripper with the component touches the top surface of base structure, without exerting a pressure thereon. A negative length represents a deformation of material around the contact points between the gripper with the component and the substrate.

Graph I shows the results for a free moving gripper guided by the drive unit. It can be seen that the substrate is moderately depressed, but that the gripper soon losses contact with the substrate.

Graph II shows the results for a gripper guided by the drive unit. However, in this case the gripper is coupled to the holder by a single pretensioned spring that exerts a force just strong enough to prevent rebounce of gripper. In this situation the gripper maintains contact with the substrate during a longer time-interval. However, the substrate is deformed about twice as much as in the first case. Graph III shows the results for a placement device according to the invention, wherein the gripper is coupled to the holder with the resilient structure comprising a first resilient portion having a relatively low stiffness and a second resilient portion having a relatively high stiffness, the first resilient portion being pretensioned. It can be concluded from the third graph in Figure 9A that the gripper maintains contact with the substrate during a longer time-interval while only moderately deforming the substrate.

Figure 9B shows the force F exerted on the substrate during the collision in the three situations I, II and III described above. In addition graph IV shows the resultant spring force between the holder and the gripper.

It can be seen in graph IV that the placement device according to the present invention the force exerted by the resilient structure on the gripper rapidly increases from zero to a predetermined value and subsequently remains substantially constant. As a result, the force exerted by the gripper on the substrate remains low, comparable to the case without a resilient structure, but a rebounce of the substrate is prevented.

Optimal values for the values of the individual spring constants can be determined by measuring the vibrations of the substrate upon a collision with the gripper or another object having the same speed and mass. Accordingly said method comprises the steps of

- causing a predetermined load to collide with the substrate,
- measuring a characteristic of vibrations of the substrate/gripper resulting from the collision,
- calculating the desired characteristic of the resilient structure from the measured characteristic.

For optimizing the force to be exerted on the gripper to prevent rebounce the collision of the gripper with component on a substrate has been modeled as a single degree of freedom damped mass-spring system. The equivalent parameters of the model have been determined by conducting a series of experiments with a gripper moveably coupled to the drive unit without any extra force added between gripper and drive unit. During the experiment the impact speed $v_{impact}$, rebounce speed $v_{rebounce}$ and contact duration $t_{contact}$ of the first collision has been measured. The experiments showed that within the measurement range of the impact speed (50-350) mm/s, the contact duration was not significantly influenced by the collision speed. The contact duration was also found out to be almost linearly proportional to the mass of the gripper. Therefore in the model a spring with constant spring stiffness has been used to represent the elastic deformation in gripper, component and substrate during the collision.

The differential equation of the model and the equations used to calculate the equivalent parameters of the model based on the measurement data are as follows:

$$m \cdot \ddot{z} + c \cdot \dot{z} + k \cdot z = F_{drive\ unit}$$

$$m_{collision} = m_{gripper} + m_{component}$$

$$k_{collision} = m_{collision} \cdot \left(\frac{2\pi}{t_{contact}}\right)^2$$

$$c_{collision} = \frac{2 \cdot \ln\left(\frac{v_{rebounce}}{v_{impact}}\right) \cdot m_{collision}}{t_{contact}}$$

In which m is mass, k is spring stiffness, c is damping, z is distance between gripper/component and substrate (negative value represents a deformation of the material around the contact points) and $t_{collision}$ is time between first moment of contact between gripper/component and substrate and the moment at which the contact is broken due to a rebounce of the gripper and component. With the model the stiffness of the spring between gripper and drive unit can be tuned such that the force on the gripper builds up just fast enough to prevent rebounce and subsequently the force build-up can be limited as much as possible (see figures 9A and 9B).

## Claims

1.  A placement device (100) comprising a gripper (110), a holder (120) and a resilient structure (130), the gripper and the holder being at least moveable relative to each other along a first axis (z), wherein the resilient structure (130) biases the gripper in a reference position relative to the holder by exerting a resultant force in a first direction along the first axis upon a change of the relative position of the gripper opposite to the first direction, wherein the resilient structure comprises a first resilient portion (131) having a relatively low stiffness and a second resilient portion (135) having a relatively high stiffness, the first resilient portion being pretensioned, **characterised in that** the first resilient portion (131) and the second resilient portion (135) cooperate to realize that a force exerted by the gripper (110) increases relatively fast to a first value ($F1_0$) upon a displacement (p) of the gripper (110) relative to the holder (120) .and remains relatively independent of said relative displacement after said first value is reached.

2.  A placement device according to claim 1, wherein the first resilient portion (135) has a first end (132) exerting a force (F1) in the first direction, and a range limiter (133) for limiting a movement of the first end in the first direction, and wherein the second resilient portion (135) exerts a force (F2) between the gripper (110) and the first end of the first resilient portion.

3.  A placement device according to claim 1, wherein the first resilient portion (231) exerts a first force upon the gripper (210) in the first direction along the first axis (z) and wherein the second resilient portion (235) exerts a second force opposite to said first direction upon the gripper until the change in relative position exceeds a predetermined value.

4.  A placement device according to claim 3, wherein the second resilient portion (235) is mounted either exclusively to the gripper or exclusively to the holder.

5.  A placement device according to claim 1, wherein the gripper (310) is guided by a first (331) and a second leaf spring (335), the gripper (310) being coupled to end portions (334, 337) of the leaf springs, which second leaf spring (335) is pretensioned against a support structure (321), wherein a portion of the second leaf spring extending beyond the support structure (321) functions as the second resilient structure.

6.  A placement device according to one of the previous claims, wherein the holder (420) and the gripper (410) are coupled by a tilting member (460) allowing the gripper to tilt away from the first axis (z).

7.  A placement device according to claim 6, wherein the tilting member (460) is formed by a membrane mounted transverse to the first axis.

8.  A placement device according to claim 6, wherein a position dependent tilt limiter (461, 435) limits the orientation of the gripper (410) to a reference orientation (z) when the gripper is in its reference position relative to the holder (420).

9.  A placement device according to claim 7, which includes a pretensioning structure (431) for applying a pretension to the membrane (460) in the first direction (z).

10. A placement device according to claim 8 or 9, wherein the position dependent tilt limiter (461, 435) includes a stop piece (461) on the gripper (410) and a support structure (435) on the holder (420), and wherein the first resilient portion forces the stop piece to the support structure in an unloaded state of the gripper.

11. An assembly device (1) comprising a placement device (100) according to any of the previous claims and further comprising a displacement device (21, 22, 23) for relatively displacing the placement device in a direction along the first axis (z) as well as a direction transverse to the first axis (x).

12. A method to calculate a desired characteristic of the resilient structure of a placement device according to one of the previous claims, comprising the steps of

    - causing a predetermined load to collide with a substrate,

    - measuring a characteristic of vibrations of the substrate and or gripper structure resulting from the collision,
    - calculating the desired characteristic of the resilient structure from the measured characteristic.

**Patentansprüche**

1.  Platzierungsvorrichtung (100) mit einem Greifer (110), einer Halterung (120) und einer elastischen Struktur (130), wobei der Greifer und die Halterung relativ zueinander mindestens entlang einer ersten Achse (z) bewegbar sind, wobei die elastische Struktur (130) den Greifer relativ zur Halterung in eine Referenzposition vorspannt, indem eine resultierende Kraft in einer ersten Richtung entlang der ersten Achse bei einer Veränderung der relativen Position des Greifers entgegen der ersten Richtung aufgebracht wird, wobei die elastische Struktur einen ersten elastischen Bereich (131) mit einer relativ geringen Steifigkeit und einen zweiten elastischen Bereich (135) mit einer relativ hohen Steifigkeit aufweist, wobei der erste elastische Bereich unter Vorspannung steht, **dadurch gekennzeichnet, dass** der erste elastische Bereich (131) und der zweite elastische Bereich (135) zusammenwirken, um zu bewirken, dass eine Kraft, die durch den Greifer (110) aufgebracht wird, bei einer Verlagerung (p) des Greifers (110) relativ zu der Halterung (120) relativ schnell auf einen ersten Wert ($F1_0$) ansteigt und, nachdem dieser erste Wert erreicht ist, von der relativen Verlagerung relativ unabhängig bleibt.

2.  Platzierungsvorrichtung nach Anspruch 1, bei der der erste elastische Bereich (135) ein erstes Ende (132), das eine Kraft (F1) in der ersten Richtung aufbringt, und einen Bereichsbegrenzer (133) aufweist, um eine Bewegung des ersten Endes in der ersten Richtung zu begrenzen, und bei der der zweite elastische Bereich (135) eine Kraft (F2) zwischen dem Greifer (110) und dem ersten Ende des ersten elastischen Bereichs aufbringt.

3.  Platzierungsvorrichtung nach Anspruch 1, bei der der erste elastische Bereich (231) eine erste Kraft auf den Greifer (210) in der ersten Richtung entlang der ersten Achse (z) aufbringt, und bei der der zweite elastische Bereich (235) eine zweite Kraft entgegen der ersten Richtung auf den Greifer aufbringt, bis die Veränderung hinsichtlich der relativen Position einen vorbestimmten Wert übersteigt.

4.  Platzierungsvorrichtung nach Anspruch 3, bei der der zweite elastische Bereich (235) entweder ausschließlich an dem Greifer oder ausschließlich an der Halterung montiert ist.

**5.** Platzierungsvorrichtung nach Anspruch 1, bei der der Greifer (310) durch eine erste (331) und eine zweite Blattfeder (335) geführt ist, wobei der Greifer (310) mit Endbereichen (334, 337) der Blattfedern gekoppelt ist, wobei die zweite Blattfeder (335) gegen eine Haltestruktur (321) vorgespannt ist, wobei ein Bereich der zweiten Blattfeder, der sich über die Haltestruktur (321) hinaus erstreckt, als die zweite elastische Struktur wirkt.

**6.** Platzierungsvorrichtung nach einem der vorhergehenden Ansprüche, bei der die Halterung (420) und der Greifer (410) durch ein Kippbauteil (460) gekoppelt sind, wodurch ermöglicht wird, dass der Greifer bezüglich der ersten Achse (z) gekippt wird.

**7.** Platzierungsvorrichtung nach Anspruch 6, bei der das Kippbauteil (460) durch eine Membran gebildet ist, die schräg zur ersten Achse montiert ist.

**8.** Platzierungsvorrichtung nach Anspruch 6, bei der ein positionsabhängiger Kippbegrenzer (461, 435) die Ausrichtung des Greifers (410) bezüglich einer Referenzausrichtung (z) begrenzt, wenn sich der Greifer relativ zur Halterung (420) in seiner Referenzposition befindet.

**9.** Platzierungsvorrichtung nach Anspruch 7, die eine Vorspannungsstruktur (431) aufweist, um eine Vorspannung auf die Membran (460) in der ersten Richtung (z) aufzubringen.

**10.** Platzierungsvorrichtung nach Anspruch 8 oder 9, bei der der positionsabhängige Kippbegrenzer (461, 435) ein Anschlagteil (461) an dem Greifer (410) und eine Haltestruktur (435) an der Halterung (420) aufweist, und bei der der erste elastische Bereich in einem unbelasteten Zustand des Greifers das Anschlagteil gegen die Haltestruktur drückt.

**11.** Zusammenbauvorrichtung (1) mit einer Platzierungsvorrichtung (100) nach einem der vorhergehenden Ansprüche und außerdem mit einer Verlagerungsvorrichtung (21, 22, 23), um die Platzierungsvorrichtung in einer Richtung entlang der ersten Achse (z) sowie in einer Richtung quer zur ersten Achse (x) relativ zu verlagern.

**12.** Verfahren zum Berechnen einer gewünschten Charakteristik der elastischen Struktur einer Platzierungsvorrichtung nach einem der vorhergehenden Ansprüche, mit den Schritten:

- Bewirken, dass eine vorbestimmte Last mit einem Substrat kollidiert,
- Messen der Charakteristik von Vibrationen des Substrats und der Greiferstruktur, die aus der Kollision resultieren,

- Berechnen der gewünschten Charakteristik der elastischen Struktur aus der gemessenen Charakteristik.

**Revendications**

**1.** Dispositif de placement (100) comprenant un préhenseur (110), un dispositif de maintien (120) et une structure résiliente (130), le préhenseur et le dispositif de maintien étant au moins mobiles l'un par rapport à l'autre le long d'un premier axe (z), dans lequel la structure résiliente (130) rappelle le préhenseur dans une position de référence par rapport au dispositif de maintien en exerçant une force résultante dans un premier sens le long du premier axe lors d'un changement de la position relative du préhenseur dans le sens opposé audit premier sens, dans lequel la structure résiliente comprend une première portion résiliente (131) de relativement faible raideur et une seconde portion résiliente (135) de relativement grande raideur, la première portion résiliente étant précontrainte, **caractérisé en ce que** la première portion résiliente (131) et la seconde portion résiliente (135) coopèrent pour qu'une force exercée par le préhenseur (110) augmente relativement rapidement jusqu'à une première valeur ($F1_0$) lors d'un déplacement (p) du préhenseur (110) par rapport au dispositif de maintien (120) et reste relativement indépendante dudit déplacement relatif une fois ladite première valeur atteinte.

**2.** Dispositif de placement selon la revendication 1, dans lequel la première portion résiliente (135) a une première extrémité (132) qui exerce une force (F1) dans le premier sens, et un limiteur de course (133) pour limiter un mouvement de ladite première extrémité dans le premier sens, et dans lequel la seconde portion résiliente (135) exerce une force (F2) entre le préhenseur (110) et la première extrémité de la première portion résiliente.

**3.** Dispositif de placement selon la revendication 1, dans lequel la première portion résiliente (231) exerce une première force sur le préhenseur (210) dans le premier sens le long du premier axe (z) et dans lequel la seconde portion résiliente (235) exerce une seconde force sur le préhenseur dans le sens opposé audit premier sens jusqu'à ce que le changement de position relative dépasse une valeur prédéterminée.

**4.** Dispositif de placement selon la revendication 3, dans lequel la seconde portion résiliente (235) est montée soit exclusivement sur le préhenseur soit exclusivement sur le dispositif de maintien.

**5.** Dispositif de placement selon la revendication 1, dans lequel le préhenseur (310) est guidé par un premier (331) et un second (335) ressort à lames, le préhenseur (310) étant couplé aux portions terminales (334, 337) des ressorts à lames, ledit second ressort à lames (335) étant précontraint contre une structure support (321), une portion du second ressort à lames, qui s'étend au-delà de la structure support (321), faisant office de seconde structure résiliente.

6. Dispositif de placement selon l'une des revendications précédentes, dans lequel le dispositif de maintien (420) et le préhenseur (410) sont couplés par un élément inclinable (460) permettant au préhenseur de s'écarter du premier axe (z).

7. Dispositif de placement selon la revendication 6, dans lequel l'élément inclinable (460) est formé par une membrane montée transversalement au premier axe.

8. Dispositif de placement selon la revendication 6, dans lequel un limiteur d'inclinaison dépendant de la position (461, 435) limite l'orientation du préhenseur (410) à une orientation de référence (z) lorsque le préhenseur se trouve dans sa position de référence par rapport au dispositif de maintien (420).

9. Dispositif de placement selon la revendication 7, incluant une structure de précontrainte (431) pour appliquer une précontrainte à la membrane (460) dans la première direction (z).

10. Dispositif de placement selon la revendication 8 ou la revendication 9, dans lequel le limiteur d'inclinaison dépendant de la position (461, 435) inclut un butoir (461) sur le préhenseur (410) et une structure support (435) sur le dispositif de maintien (420), et dans lequel la première portion résiliente plaque le butoir contre la structure support lorsque le préhenseur n'est pas chargé.

11. Dispositif d'assemblage (1) comprenant un dispositif de placement (100) selon l'une quelconque des revendications précédentes et comprenant en outre un dispositif de déplacement (21, 22, 23) pour assurer le déplacement relatif du dispositif de placement dans une direction le long du premier axe (z) ainsi que dans une direction transversale au premier axe (x).

12. Procédé de calcul d'une caractéristique souhaitée de la structure résiliente d'un dispositif de placement selon l'une quelconque des revendications précédentes, comprenant les étapes consistant à

- provoquer la collision d'une charge prédéterminée avec un substrat,

- mesurer une caractéristique vibratoire du substrat et/ou de la structure de préhension suite à la collision,
- calculer la caractéristique souhaitée de la structure résiliente à partir de la caractéristique mesurée.

Fig. 1

Fig. 2

Fig. 2A

F1

131
132
133
120
135

F2

110

121

Fig. 2B

F1

131
132
133
120
135

F2

110

121

Fig. 2C

F1

131
132
133
120
135

F2

110

121

EP 2 172 091 B1

13

Fig. 3

**Fig. 4**

EP 2 172 091 B1

Fig. 5

Fig. 6

Fig. 7A

Fig. 7B

Fig. 8A

Fig. 8B

EP 2 172 091 B1

Fig. 9A

Fig. 9B

EP 2 172 091 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050035613 A

- JP 2007027408 A